# EUROPEAN PATENT SPECIFICATION

(11) **EP 0 605 725 B1**
(45) Date of publication and mention of the grant of the patent: **25.08.1999**
(21) Application number: 92920362.8
(22) Date of filing: 28.09.1992
(51) Int. Cl.: C30B 25/14, C23C 16/44

(54) **APPARATUS FOR INTRODUCING GAS, AND APPARATUS AND METHOD FOR EPITAXIAL GROWTH**
VORRICHTUNG ZUM EINFÜHREN VON GAS, SOWIE GERÄT UND VERFAHREN ZUM EPITAXIALEN WACHSTUM.
APPAREIL POUR L'INTRODUCTION D'UN GAZ, ET APPAREIL ET PROCEDE DE CROISSANCE EPITAXIALE

(30) Priority: 27.09.1991 JP 24979691; 28.02.1992 JP 4329392
(43) Date of publication of application: 13.07.1994
(73) Proprietor: KOMATSU ELECTRONIC METALS CO., LTD, Hiratsuka-shi Kangawa 254 (JP); KABUSHIKI KAISHA KOMATSU SEISAKUSHO, Minato-ku Tokyo 107 (JP)
(72) Inventor: MARUYA, Shinji Komatsu Electronic Metals Co. Ltd., Kanagawa 254 (JP); KATO, Hiroki Komatsu Electronic Metals Co., Ltd., Hiratsuka-shi Kanagawa 254 (JP); HINO, Kazuhiko Kabushiki Kaisha Komatsu, Hiratsuka-shi Kanagawa 254 (JP); KOBAYASHI, Masakazu Kabushiki Kaisha Komatsu, Hiratsuka-shi Kanagawa 254 (JP); OCHI, Nozomu Kabushiki Kaisha Komatsu Seisakusho, Hiratsuka-shi Kanagawa 254 (JP); HISANAGA, Naoto Kabushiki Kaisha Komatsu, Hiratsuka-shi Kanagawa 254 (JP)
(74) Representative: Blumbach, Kramer & Partner GbR
(86) International application number: JP9201235
(87) International publication number: WO9306619

(56) References cited:
- JP-A- 55 121 650
- JP-A- 56 078 497
- JP-A- 56 137 639
- JP-U- 61 158 947
- US-A- 4 499 853
- DATABASE WPI Section Ch, Week 8922 Derwent Publications Ltd., London, GB; Class L03, AN 89-163070 & JP-A-01 107 519 ( NEC CORP) , 25 April 1989 & PATENT ABSTRACTS OF JAPAN vol. 13 no. 348 (E-799) ,4 August 1989 & JP-A-01 107519 (NEC CORP) 25 April 1989,
- PATENT ABSTRACTS OF JAPAN vol. 012 no. 110 (C-486) ,8 April 1988 & JP-A-62 235472 (SHARP CORP) 15 October 1987,

## Description

The present invention relates to an apparatus for introducing a gas, and an apparatus and a method for epitaxial growth, and more particularly to the formation of a single-crystal thin film excelling in crystallinity.

US-A-4 499 853 discloses an apparatus for chemically vapor depositing silicon material on surfaces of a plurality of substrates arranged in a stack that is continuously rotating. The apparatus comprises a gas distributor which is formed of a pair of coaxial tubes and provides a pair of gas streams from a pair of parallel slots extending lengthwise of the tube and facing the substrates. Gas is supplied through the inner tube and is passed through holes conducting gas from the inner tube to the outer tube and into the depositing chamber.

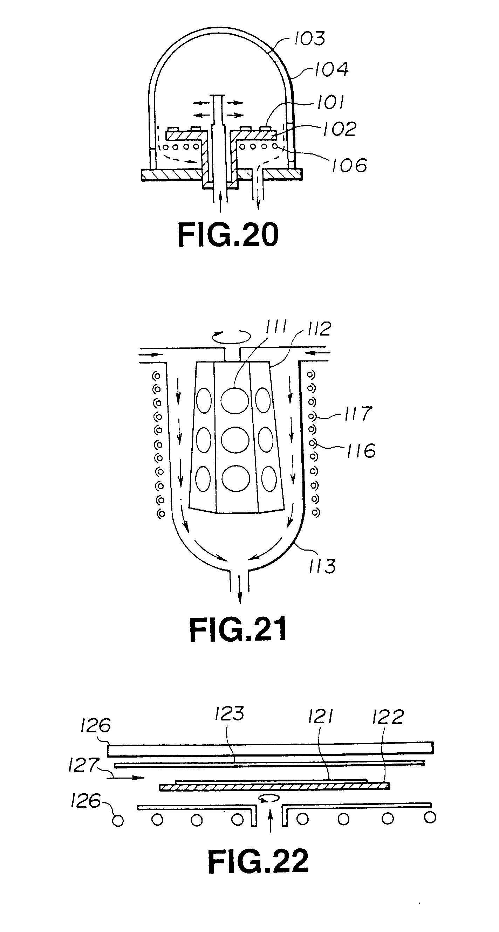

Apparatuses for epitaxial growth which have conventionally been used include the following types: a vertical furnace type in which, as shown in Fig. 20, a susceptor 102 with wafers 101 placed thereon is heated by means of a high-frequency coil 106, and a reactive gas is introduced while the wafers are being heated thereby indirectly so as to form epitaxially grown films on wafer surfaces; a cylindrical furnace type in which, as shown in Fig. 21, wafers 111 are placed on a cylindrical susceptor 112 for placing the wafers 111 thereon, and heating is effected by infrared lamps 116 disposed on the outer side of a chamber 113; and a sheet-type furnace in which, as shown in Fig. 22, a wafer 121 is placed on a tabular susceptor 122 disposed in a chamber 123 consisting of a square-shaped quartz pipe, and heating is effected by using infrared lamps 126 provided on the outer side of the chamber 123.

Of these types, in the case of the vertical furnace type, since the wafers are heated indirectly, there is a problem in that the temperature difference between the obverse and reverse sides of the wafers becomes large, and that a slip (crystal dislocation) is hence liable to occur. In addition, in each of these types, a multiplicity of wafers can be processed simultaneously; however, since the wafer temperature cannot be made uniform, there are problems in that the film thickness becomes nonuniform, and that variations of specific resistance can occur.

In the case of the cylindrical furnace type, a multiplicity of wafers can be processed at a time, and the wafers are heated directly by the radiant heat from the infrared lamps 116, and are heated by thermal conduction from the susceptor 112. Therefore, the temperature difference between the obverse and reverse sides of the wafers becomes small, with the result that the occurrence of the slip can be suppressed.

It is known that the epitaxially grown films can be formed best at a low temperature if silane SiH₄ is used as a reactive gas in such gaseous-phase growth of silicon, in which case automatic doping and pattern shift can be controlled.

However, if epitaxial growth using silane SiH₄ is carried out, this silane gas starts to be thermally decomposed at 300°C or thereabouts. Consequently, silicon which is decomposed in the gaseous phase is deposited on an inner wall of the quartz chamber 113, is transformed into amorphous silicon, and absorbs radiant heat, thereby making radiant heating difficult. For this reason, only three kinds of source gases, SiH₂Cl₂, SiHCl₃, and SiCl₄, which are low in thermal decomposition, can be used.

In conjunction with the tendency in recent years toward production of large-diameter silicon wafers, the nonuniformity of film thickness in the wafers has become noticeable, and the sheet-type furnace for processing wafers one at a time has come to attract attention again.

The sheet-type furnace is arranged such that, as shown in Fig. 22, a wafer 121 is placed on a tabular susceptor 122 disposed in a chamber 123 consisting of a square-shaped quartz pipe, and heating is effected by using an infrared lamps 126 provided on the outer side of the chamber 123. Since the distance from a heat source can be fixed, and the wafer temperature can be maintained at a fixed level, there is a problem in that the throughput (the number of wafers processed per unit time) is poor. Nevertheless, it is possible to form films which are uniform and small in variations in the specific resistance.

However, since radiant heat is used in this case as well, silicon which is decomposed in the gaseous phase is deposited on an inner wall of the chamber 123 and absorbs radiant heat, thereby making radiant heating difficult. For this reason, only three kinds of source gases, SiH₂Cl₂, SiHCl₃, and SiCl₄, which are low in thermal decomposition, can be used.

Thus, in both the conventional cylindrical furnace type and sheet-type furnace, the epitaxially grown films could be formed best if SiH₄ were used as a source gas, and yet there has been the problem that SiH₄ cannot be used.

As such, in the conventional apparatuses for epitaxial growth, in both cases of the conventional cylindrical furnace type and sheet-type furnace, silicon which is decomposed in the gaseous phase is deposited on the inner wall of the chamber and absorbs radiant heat, making radiant heating difficult. As a result, there has been a drawback in that since SiH₄ which is high in thermal decomposition cannot be used as the source gas, it is impossible to form epitaxially grown films excelling in crystallinity at a low temperature.

Furthermore, in gaseous-phase growth apparatuses such as the apparatuses for epitaxial growth, since the film formation is effected on the basis of the material transportation speed, it is necessary to introduce a uniform and reproducible gas flow into a reaction container in order to form a film of a uniform and a specific thickness.

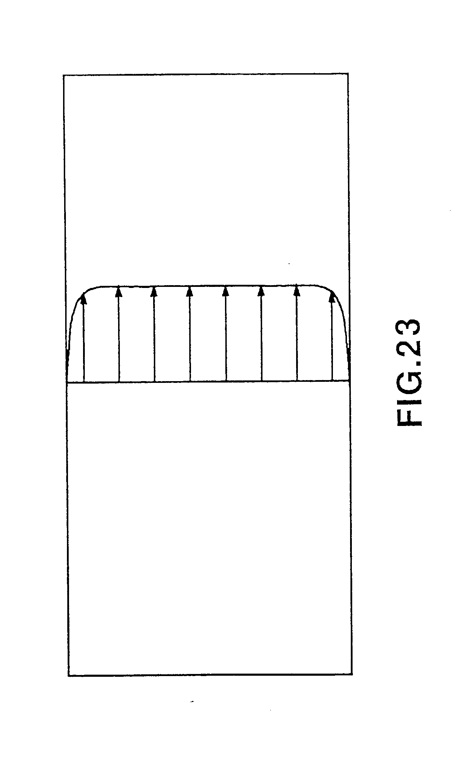

It is conventionally known that, as shown in Fig. 23, the distribution of a rate of longitudinal flow of a fluid flowing through a rectangular pipe of a high aspect ratio becomes uniform in the longitudinal direction when the flow is developed sufficiently (The Japan Society of Mechanical Engineers "JSME Data Book: Hydraulic Losses in Pipes and Ducts," p. 39, January 20, 1979). However, since a long passage is required for the flow to develop sufficiently, the apparatus becomes huge, and such an arrangement is impractical.

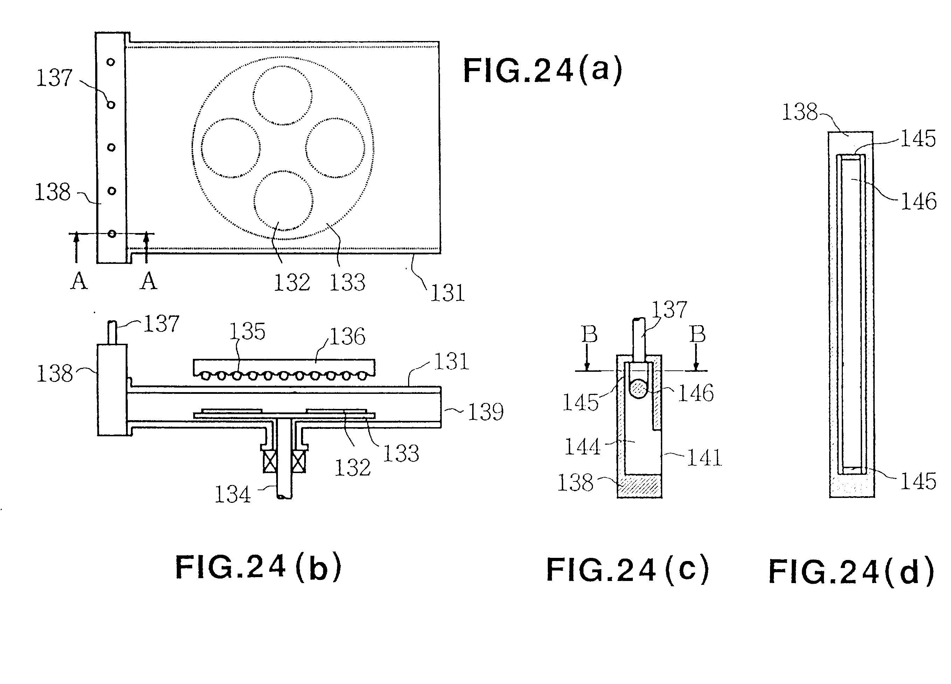

Accordingly, to overcome this problem, as shown in Figs. 24(a) to 24(d), a flow of a reaction gas, which is uniform in the widthwise direction of a reaction furnace 131, is formed from gas inlet ports 137 via a gas-introducing unit 138 (Japanese Patent Application Laid-Open JP-A-131494/1991). Fig. 24(a) is a top plan view; Fig. 24(b) is a cross-sectional view; Fig. 24(c) is a cross-sectional view taken along line A - A in Fig. 24(a); and Fig. 24(d) is a cross-sectional view taken along line B - B in Fig. 24(c). In this apparatus, a circular susceptor 133 for placing a plurality of wafers 132 thereon is disposed in the reaction furnace 131. The susceptor 133 is pivotally supported by a rotating shaft 134 which is connected to a motor (not shown), so that the susceptor 133 is rotatable. Infrared lamps 135 for heating the wafers 132 and the susceptor 133 are juxtaposed to the outside of the reaction furnace 131, and a reflecting plate 136 is provided in the rear of the infrared lamps 135. A gas introducing unit 138 in which five gas inlet ports 137 are open is provided at one end of the reaction furnace 131, and an exhaust port 139 is provided at the other end of the reaction furnace 131. Gas supplying pipes (not shown) connected to a gas source are connected to the respective gas inlet ports 137, and the reaction gas introduced from the gas inlet ports 137 passes through the gas introducing unit 138 communicating therewith and is supplied to the reaction furnace 131.

A passage 144 communicating with a gas-introducing-unit outlet port 141 is formed in the gas introducing unit 138 from the respective gas inlet ports 137. Suspension plates 145 are provided at both ends of the gas introducing unit 138, a distance between the suspension plates 145 being substantially identical to the width of the reaction furnace 131. A round rod 146 whose longitudinal axis is arranged in the widthwise direction of the reaction furnace 131 is suspended from these suspension plates 145 in the passage 144 of the gas introducing unit 138. By virtue of this arrangement, the reaction gas introduced from the gas inlet ports 137 is caused to collide against the round rod 146 so as to prompt its diffusion in the widthwise direction of the reaction furnace 131, and is caused to flow out from gaps between the round rod 146 and the passage 144, thereby to attain a uniform gas flow in the widthwise direction in the reaction furnace 131.

In this structure, since the structure is arranged such that the reaction gas is introduced from the gas inlet ports 137 and is caused to collide against the round rod 146, there has been a drawback in that the distribution in the widthwise direction of the reaction gas on the downstream side of the round rod 146 is liable to maintain a distribution conforming to the distribution of the gas inlet ports 137.

To overcome this problem, it is conceivable to adopt methods such as increasing the length of the gas introducing unit, increasing the number of the gas inlet ports 137, and reducing the gaps between the round rod 146 and the passage 144. However, there arise problems in that the apparatus becomes large, the arrangement becomes complicated, and it is difficult to maintain the clearance of the gap to a fixed dimension in the widthwise direction.

In the vertical furnace type shown in Fig. 20 and the cylindrical furnace type shown in Fig. 21, after the interior of the chamber is purged with a nitrogen gas and is subsequently purged with a hydrogen gas, the interior of the chamber is heated to 1150 - 1200°C in a hydrogen atmosphere. A hydrogen chloride gas is then added to remove natural oxide films on the wafer surfaces. Subsequently, the interior of the chamber is cooled to 1000 - 1150°C, and trichlorosilane (SiHCl₃) or the like is supplied to effect epitaxial growth, whereupon a nitrogen purge is conducted, and the wafers are removed. The cycle time in this case is 1 to 2 hours although it depends on the thickness of the epitaxially grown layer and the type of the growth gas.

Meanwhile, in the sheet-type furnace such as the one shown in Fig. 22, after the interior of the chamber 123 consisting of a square-shaped quartz pipe is purged with a nitrogen gas and is subsequently purged with a hydrogen gas, the interior of the chamber 123 is heated to 1150 - 1200°C by the infrared lamps 126, and a hydrogen chloride gas is added to remove a natural oxide film on the wafer surface. Then, the interior of the chamber is cooled to 1000 - 1150°C, and trichlorosilane (SiHCl₃) or the like is supplied to effect epitaxial growth, whereupon the interior of the chamber is cooled to 900°C, and the wafer is removed in a hydrogen atmosphere.

In such a sheet-type furnace, in order to reduce the process time, RTP (rapid thermal process) for increasing the growth rate and using infrared lamps is adopted, thereby attaining rapid heating.

However, because radiant heat is used, there has been a problem in that silicon which is decomposed in the gaseous phase is deposited on the inner wall of the chamber 123 and absorbs radiant heat, thereby making radiant heating difficult or causing the occurrence of particles.

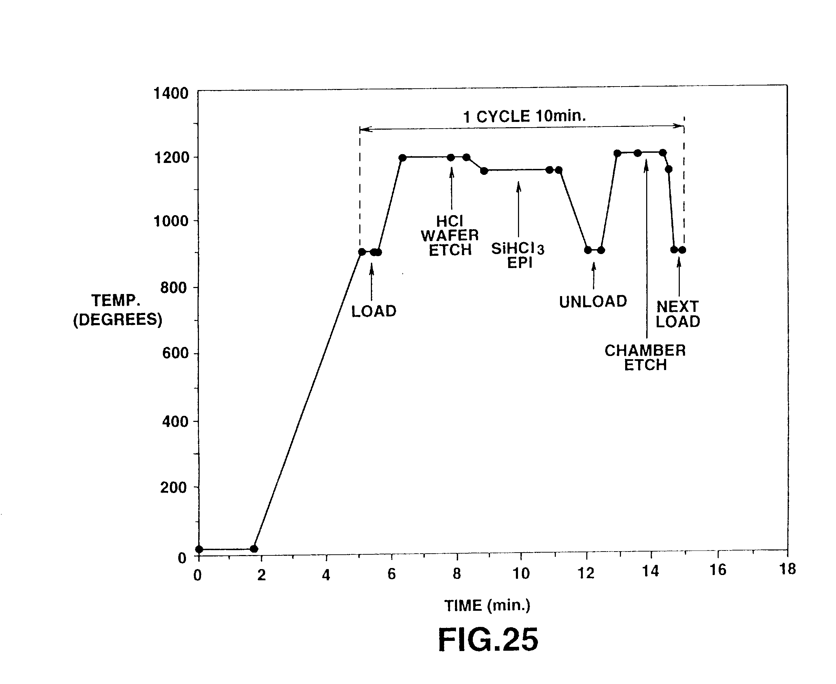

Accordingly, after the wafer is removed, the interior of the chamber is heated again to 1200°C or thereabouts, the inner wall of the quartz chamber is etched with an HCl gas or the like to remove the adherent silicon each time. Subsequently, the interior of the chamber is cooled to 900°C or similar temperature to carry out the process for an ensuing wafer. In this case, as a time chart is shown in Fig. 25, the chamber etching time is approximately 3 minutes or thereabouts, and accounts for about 30% of the 10-minute cycle time when epitaxial growth is effected with trichlorosilane.

Thus, in the case of the sheet-type furnace, the HCl etching of the chamber is unfailingly conducted after the epitaxial growth so as to remove amorphous silicon adhering to the chamber. However, since only about 80 - 90% of the adhering substance can be removed by the etching by means of the HCl gas, it becomes difficult to completely remove the adhering substance as the growth is carried out continuously. For this reason, in correspondence with the situation of the adhering substance the growth apparatus is disassembled, the quartz chamber is removed, and etching is performed by means of a hydrofluoric and nitric acid (a mixed solution of hydrofluoric acid (HF) and nitric acid (HNO₃)).

This problem applies to not only the sheet-type furnace but also the vertical furnace type and the cylindrical furnace type.

Thus, with the conventional apparatuses for epitaxial growth, in the cases of both the cylindrical furnace type and the sheet-type furnace, silicone which is decomposed in the gaseous phase is deposited on the inner wall of the chamber, absorbs radiant heat, and makes radiant heating difficult. Hence, the etching or cleaning of the inner wall of the chamber is unfailingly required, which has constituted a cause of preventing continuous growth.

The present invention has been devised in view of the above-described circumstances, and its object is to provide an apparatus and a method for epitaxial growth which make it possible to obtain an epitaxially grown film which is uniform and is reliable at a low temperature.

Another object of the present invention is to provide an apparatus for introducing a gas which makes it possible to uniformalize the distribution of a flow rate.

Still another object of the present invention is to provide a method for epitaxial growth which makes it possible to obtain highly reliable epitaxially grown films on a continuous basis.

These objects are achieved by an apparatus in accordance with claim 1, a method in accordance with claim 5, and an apparatus in accordance with claim 10, respectively.

Accordingly, in accordance with a first aspect of the present invention, a reactive gas is supplied in such a manner as to form a laminar flow of a multilayered structure along the surface of a wafer so as to effect epitaxial growth on the surface of the wafer.

In accordance with a second aspect of the present invention, epitaxial growth may be carried out while a gas which is low in reactivity is allowed to flow along the inner wall of the chamber as a seal gas while forming a laminar flow.

In accordance with a third aspect of the present invention, a plurality of laminar flow-forming units for introducing a gas in such a manner as to form a laminar flow of a multilayered structure along the surface of the wafer is disposed at a gas inlet port of the apparatus for epitaxial growth.

A gas introducing portion of this apparatus for epitaxial growth is arranged such that a gas is blown temporarily toward a rear surface from introducing holes formed in a hollow rod passed in the widthwise direction, and the gas, after being reflected by the wall of the rear surface, is passed through gaps respectively formed between the hollow rod and each of upper and lower walls of the gas introducing portion so as to be rectified.

A reaction gas is supplied onto a surface of a substrate to be processed in such a manner as to form a laminar flow of a multilayered structure along the surface of the substrate to be processed, and epitaxial growth is conducted on a continuous basis without undergoing a temperature-increasing step for etching an inner wall of the chamber.

Preferably, a reactive gas is allowed to flow while a gas which is low in reactivity and forming a laminar flow, flows along the inner wall of the chamber as a seal gas so as to effect epitaxial growth, and epitaxial growth is conducted on a continuous basis without undergoing a temperature-increasing step for etching an inner wall of the chamber.

Since the reactive gas is supplied in such a manner as to form a laminar flow of a multilayered structure along the wafer surface so as to effect epitaxial growth on the wafer surface, it is possible to prevent the reactive gas from flowing round to the inner wall of the chamber and adhering to the inner wall by being decomposed. Thus; it is possible to use a highly decomposable SiH₄ gas or the like as a source gas, so that it is possible to form an epitaxially grown film which is highly reliable at a low temperature.

Preferably, a source gas which is highly decomposable, such as SiH₄, is set on the wafer side, and a gas such as a carrier gas which is low in reactivity is set on the chamber side, whereby reaction progresses only on the wafer surface, and the inner wall of the chamber is maintained satisfactorily without an adhering substance. More preferably, a seal gas which is slightly reductive is allowed to flow on the chamber side, whereby the inner wall of the chamber is maintained clean while the adhering substance is being removed, thereby making it possible to obtain an excellent condition over extended periods of time.

In addition, since the epitaxial growth is carried out while a gas which is low in reactivity is allowed to flow along the inner wall of the chamber as the seal gas, it is possible to prevent the decomposed substance from reaching the inner wall of the chamber, thereby making it possible to maintain the inner wall in an excellent condition without an adhering substance.

Since a plurality of laminar flow-forming units for introducing a gas in such a manner as to form a laminar flow of a multilayered structure along the wafer surface is disposed at the gas inlet portion of the apparatus for epitaxial growth, the reactive gas is supplied in such a manner as to form a laminar flow of a multilayered structure along the wafer surface. Hence, it is possible to prevent the reactive gas from flowing round to the inner wall of the chamber and adhering to the inner wall by being decomposed. Thus, it is possible to use a highly decomposable SiH₄ gas or the like as a source gas, so that it is possible to form an epitaxially grown film which is highly reliable at a low temperature.

In a system in which epitaxial growth is effected by placing the wafer horizontally, it is preferable to use as the seal gas a gas which is light and low in reactivity, such as a hydrogen gas. A gas which is low in reactivity but heavy, such as a nitrogen gas, is not preferable. The reason for this is that if the seal gas is heavy, the seal gas covers the wafer surface, thereby preventing the reaction of the surface.

These arrangements are particularly effective in a system in which the wafer is heated by means of radiant heat. In the case of other types of systems as well, since the adhering substance is not produced on the inner wall of the chamber, the life is prolonged, and it is possible to form an epitaxially grown film which is excellent in film quality without the mixing in of impurities due to the exfoliation of the adhering substance.

When the gas introducing portion is arranged such that a gas is blown temporarily toward the rear surface from introducing holes formed in the hollow rod passed in the widthwise direction, and the gas, after being reflected by the wall of the rear surface, is passed through the gaps respectively formed between the hollow rod and each of upper and lower walls of the gas introducing portion so as to be rectified, it is possible to very efficiently form a laminar flow which is uniform in the widthwise direction.

Preferably, another rectifying means may be provided farther on the downstream side.

Since the reactive gas is supplied in such a manner as to form a laminar flow of a multilayered structure along the wafer surface so as to effect epitaxial growth on the wafer surface, it is possible to prevent the reactive gas from flowing round to the inner wall of the chamber and adhering to the inner wall by being decomposed. Thus, it is possible to form an epitaxially grown film which is highly reliable on a continuous basis without performing a chamber etching step between the steps. Hence, it is possible to substantially reduce the cycle time required for growth.

Preferably, a source gas which is more decomposable, such as monosilane (SiCl₄), dichlorosilane (SiH₂Cl₃), trichlorosilane (SiHCl₃), or tetrachlorosilane (SiCl₄), is set on the wafer side, and a gas such as a carrier gas which is low in reactivity is set on the chamber side. As a result, reaction progresses only on the wafer surface, a decomposed substance is prevented from etching the inner wall of the chamber, and the inner wall of the chamber is maintained satisfactorily without an adhering substance. More preferably, a seal gas which is slightly reductive is allowed to flow on the chamber side, whereby the inner wall of the chamber is maintained clean while the adhering substance is being removed, thereby making it possible to obtain an excellent condition over extended periods of time.

In a system in which epitaxial growth is effected by placing the wafer horizontally, it is preferable to use as the seal gas a gas which is light and low in reactivity, such as a hydrogen gas. A gas which is low in reactivity but heavy, such as a nitrogen gas, is not preferable. The reason for this is that if the seal gas is heavy, the seal gas covers the wafer surface, thereby preventing the reaction of the surface.

These arrangements are particularly effective in a system in which the wafer is heated by means of radiant heat. In the case of other types of systems as well, since the adhering substance is not produced on the inner wall of the chamber, the life is prolonged, and it is possible to form an epitaxially grown film which is excellent in film quality without the mixing in of impurities due to the exfoliation of the adhering substance.

### BRIEF DESCRIPTION OF THE DRAWINGS

Figs. 1(a) to 1(c) are diagrams illustrating a CVD apparatus;
Fig. 2 is an explanatory diagram of an essential portion of the CVD apparatus;
Figs. 3(a) to 3(d) are diagrams illustrating distributions of flow rates of the CVD apparatus;
Fig. 4 is a diagram illustrating a modification of a gas introducing unit in accordance with the embodiment of the present invention;
Figs. 5(a) and 5(b) are diagrams illustrating another modification of the gas introducing unit in accordance with the embodiment of the present invention;
Fig. 6 is a diagram illustrating still another modification of the gas introducing unit in accordance with the embodiment of the present invention;
Figs. 7(a) to 7(c) are diagrams illustrating distributions of flow rates of the CVD apparatus;
Figs. 8(a) and 8(b) are diagrams illustrating an apparatus for introducing a gas in accordance with a second embodiment of the present invention;
Figs. 9(a) and 9(b) are enlarged views of an essential portion of the apparatus;
Fig. 10 is a diagram illustrating a modification of a gas introducing unit in accordance with the embodiment of the present invention;
Figs. 11(a) and 11(b) are diagrams illustrating another modification of the gas introducing unit in accordance with the embodiment of the present invention;
Figs. 12(a) and 12(b) are diagrams illustrating still another modification of the gas introducing unit in accordance with the embodiment of the present invention;
Figs. 13(a) and 13(b) are diagrams illustrating a further modification of the gas-introducing unit in accordance with the embodiment of the present invention;
Figs. 14(a) and 14(b) are diagrams illustrating a further modification of the gas introducing unit in accordance with the embodiment of the present invention;
Figs. 15(a) and 15(b) are diagrams illustrating a further modification of the gas introducing unit in accordance with the embodiment of the present invention;
Figs. 16(a) and 16(b) are explanatory diagrams of a different CVD apparatus;
Fig. 17 is an explanatory diagram of an essential portion of the CVD apparatus of Fig. 16(a);
Figs. 18(a) to 18(e) are diagrams illustrating distributions of flow rates of the CVD apparatus of Fig. 16(a);
Fig. 19 is a time chart of a method for epitaxial growth in accordance with the embodiment of the present invention;
Fig. 20 is a diagram illustrating a conventional apparatus for epitaxial growth;
Fig. 21 is a diagram illustrating another conventional apparatus for epitaxial growth;
Fig. 22 is a diagram illustrating still another conventional apparatus for epitaxial growth;
Fig. 23 is a diagram illustrating the distribution of a flow rate of the conventional apparatus for epitaxial growth;
Figs. 24(a) to 24(d) are diagrams illustrating a further conventional apparatus for epitaxial growth; and
Fig. 25 is a diagram illustrating a time chart of a conventional method for epitaxial growth.

Hereafter, a detailed description will be given of the embodiments of the present invention with reference to the drawings.

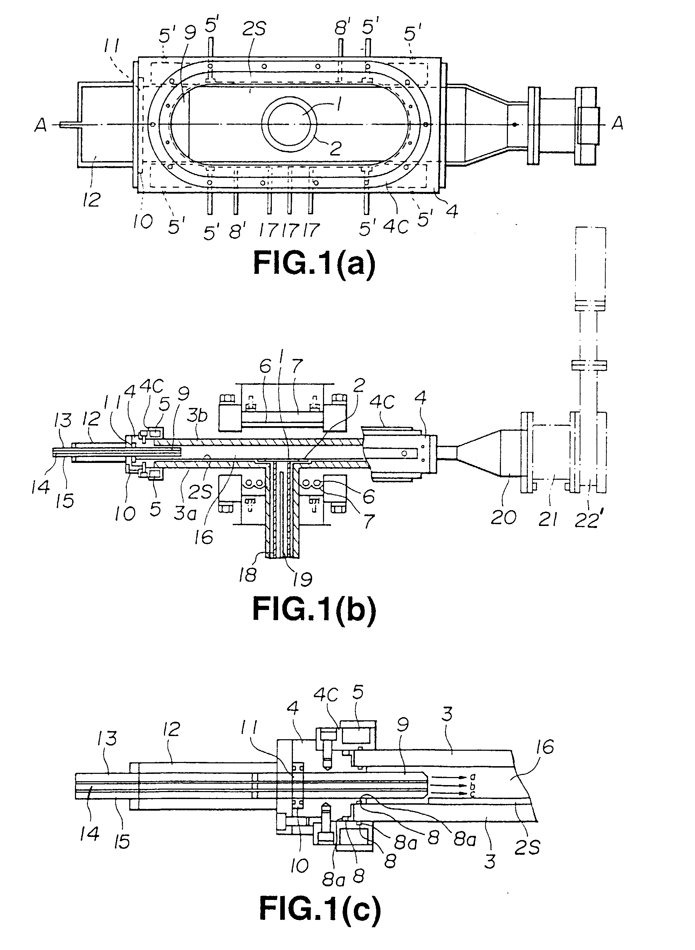

Figs. 1(a) to 1(c) are schematic diagrams of a CVD apparatus which, however, does not comprise a buffer tank and gas introducing pipe arranged as claimed in the claims.

This CVD apparatus comprises three gas inlet ports for supplying gases into a chamber 16 which are formed starting with an inner wall side of the chamber, including a seal gas inlet port 13, a carrier gas inlet port 14, and a source gas inlet port 15, and the respective gases are arranged to flow through the chamber by forming a laminar flow of three layers by means of a shroud 9 via a buffer tank 12 which is divided into three chambers. A mesh-like filter 11 made of a metal or quartz is mounted between the buffer tank 12 and the shroud 9 by means of a plate 10 so as to make uniform the flow rate of the gas in each layer. Here, a hydrogen H₂ gas or the H₂ gas with hydrogen chloride HCl added is supplied from the seal gas inlet port 13; the H2 gas is supplied from the carrier gas inlet port 14; and SiH₄ diluted with H₂ is supplied from the source gas inlet port 15. The gases introduced into the chamber 16 are exhausted via a duct 20, a bellows flange 21, a gate valve 22', and the like. In addition, the chamber 16 is characterized by comprising two elliptical quartz plates 3a, 3b which are optically ground and polished, and which are disposed in parallel with each other with a predetermined interval therebetween, and a stainless side wall plate 4 disposed in such a manner as to clamp these members and cover their peripheries. It should be noted that this side wall plate 4 is coated with amorphous tantalum, and its outer side has a water-cooled structure.

These two elliptical quarts plates 3a, 3b are sealed by O-rings 8 by means of a water-cooled stainless cover 4C, and are attached to the side wall plate 4.

The gas is supplied from the gas inlet port 13 toward the duct 20 so that the reactive gas will be introduced along the longitudinal axis of the elliptical shape.

A wafer 1 is placed on a susceptor 2 disposed in this chamber 16 so as to allow epitaxial growth to take place.

Here, the O-rings 8 are cooled by a water-cooled jacket 5 to maintain their sealing properties even at a high temperature. In addition, the O-rings 8 allow an N₂ gas to purge an O-ring groove 8a so as to detect the leakage of the SiH₄ gas.

Further, this susceptor 2 is formed of high-purity graphite in which a counterbore is formed in a wafer-placing portion, and whose surface is coated with SiC. The susceptor 2 is mounted on a rotating shaft of a rotating means 18 having a rotating cylinder provided on the quartz plate 3a. Also, an optical fiber 19 is mounted in this rotating cylinder so as to permit the monitoring of the temperature of the reverse surface of the wafer.

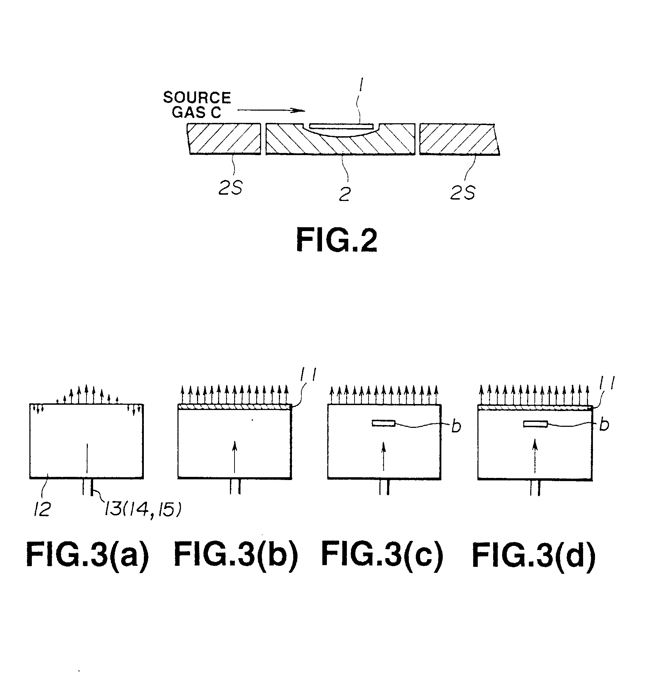

Furthermore, a second susceptor 2S formed of quartz is mounted on the surface of the quartz plate 3a such that its upper surface becomes substantially flush with the obverse surface of the wafer 1 on the susceptor 2, as an enlarged view of an essential portion is shown in Fig. 2, so as to introduce the gas satisfactorily.

The counterbore provided in the susceptor 2 serves to suppress the occurrence of crystal dislocation and to prevent the turbulence of a gas flow at an edge of the wafer by making the surface of the wafer flush with or lower than those of the susceptors 2, 2S.

The wafer is heated by infrared lamps 6 which are disposed outside the quartz plates 3a and 3b at upper and lower positions in directions which are perpendicular to each other. These infrared lamps are provided with reflectors 7 whose inner walls are plated with gold, so as to enhance the thermal efficiency.

Furthermore, thermocouple insertion ports 17 for inserting thermocouples for monitoring the temperature are provided in the side wall plate.

By using this apparatus, the silicon wafer 1 is placed on the susceptor 2, and a gas of a three-layered structure is introduced from the gas inlet port 13 toward the silicon wafer 1. The temperature of the reverse surface of the susceptor is detected by the thermocouples inserted through the thermocouple insertion ports 17 in the side wall, while the temperature of the reverse surface of the wafer is detected by the optical fiber 19. On the basis of their detected values, the amount of light from the infrared lamps is controlled, thereby adjusting the wafer temperature with high accuracy. Here, the wafer temperature is set to 850 - 1200°C.

Next, a description will be given of a method for epitaxial growth using this apparatus for epitaxial growth. First, the silicon wafer 1 is placed on the susceptor 2, and the susceptor 2 is rotated by means of the rotating means 18.

Then, the nitrogen N₂ gas is supplied from the gas inlet ports 13, 14, 15 to purge-the interior of the chamber 16 with N₂.

Subsequently, the hydrogen H₂ gas is supplied from the gas inlet ports 13, 14, 15 to purge the interior of the chamber 16 with H₂, and the wafer is heated to the epitaxial growth temperature (900 - 1050°C) by the infrared lamps 6 in the H₂ atmosphere.

When the growth temperature is reached, the hydrogen H₂ gas or the H₂ gas with hydrogen chloride HCl added is supplied from the seal gas inlet port 13; the H₂ gas is supplied from the carrier gas inlet port 14; and SiH₄ diluted with H₂ is supplied from the source gas inlet port 15. These supplying conditions and the like are shown in the table below.

**Table 1**

| | |
|---|---|
| Growth temperature | 950 - 1050°C |
| Seal gas H₂ | 150 SLM |
| | 0.3 - 5.0 m/sec |
| Carrier gas H₂ | 200 SLM |
| | 0.3 - 5.0 m/sec |
| Source gas SiH₄/Carrier gas H₂ | 150 sccm |
| | 30 SLM |
| | 0.1 - 3.5 m/sec |
| Thickness of epitaxial film | 2.7 µm |
| Growth speed | 0.8 - 1.5 µm/min |

When the gases were supplied under these supplying conditions, the distribution of the flow rate in each layer was a laminar flow, as shown in Fig. 3(b).

The hydrogen H₂ gas supplied from the seal gas inlet port 13 flowed along the upper quartz plate 3b; the H₂ gas supplied from the carrier gas inlet port 14 flowed in a central portion of the chamber; and SiH₄ diluted with H₂ introduced from the source gas inlet port 15 flowed along the wafer surface, thereby forming an epitaxially grown silicon film on the wafer surface.

The epitaxially grown film thus obtained is a film which is slip-free and excellent in crystallinity, and since it is formed at a lower temperature, there is no risk of the occurrence of automatic doping or pattern shift.

Furthermore, since the inner wall of this stainless plate is covered with amorphous tantalum which has very low reactivity and is stable, it is possible to form an epitaxial thin film which is very stable and highly reliable.

It should be noted that although, in the foregoing device, the flow rate in each layer is made uniform by the use of the filter 11, a baffle plate b instead of the filter may be inserted in the buffer tank (Fig. 3(c)), or both the filter and the baffle plate b may be used (Fig. 3(d)). Here, in a case where the filter is not used, the flow rate in the layer has not become uniform and a turbulent flow is formed, as shown in Fig. 3(a).

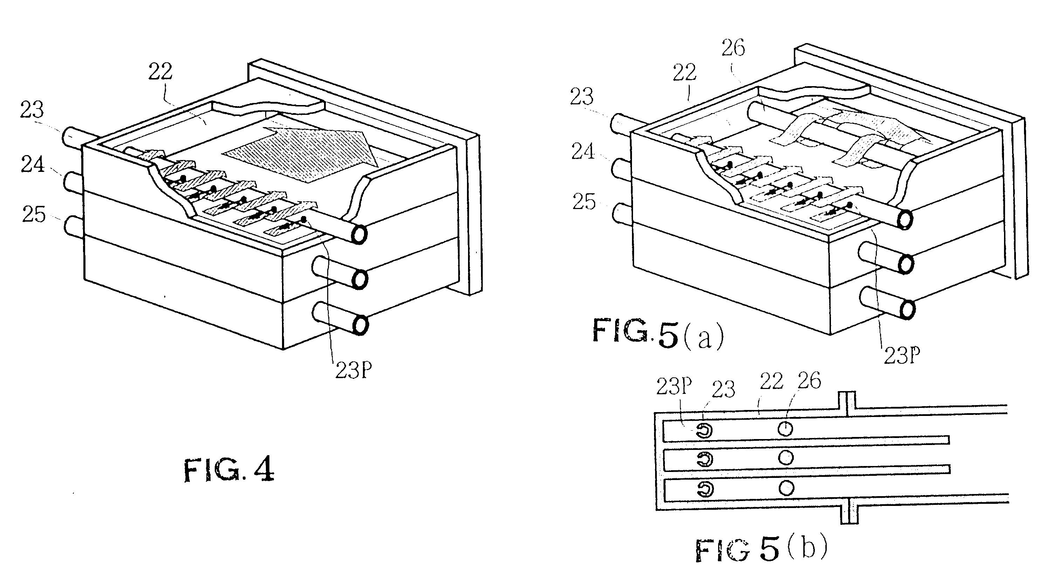

Therefore, this gas introducing unit is arranged as shown in Fig. 4.

In this structure, gas introducing pipes for supplying gases into the chamber 16 are arranged such that a seal-gas introducing pipe 23, a carrier-gas introducing pipe 24, and a source-gas introducing pipe 25 are superposed one above another in three layers starting with the inner wall side of the chamber, and gases flow through the chamber by forming a laminar flow of three layers by means of the shroud 9 (see Fig. 1) via a buffer tank 22 which is divided into three chambers.

In this apparatus, the seal gas, which is supplied from both ends of the gas introducing pipe 23, is supplied in a direction away from the chamber 16, i.e., toward the rear surface of the buffer tank, and is caused to collide against the rear surface. The seal gas then passes through gaps formed respectively between the gas introducing pipe 23 and each of the upper and lower walls of the buffer tank 22, thereby making it possible to obtain a uniform flow rate in the widthwise direction. As for the gases which are supplied from the gas introducing pipes 24, 25 as well, uniform flow rates are similarly obtained in the widthwise direction.

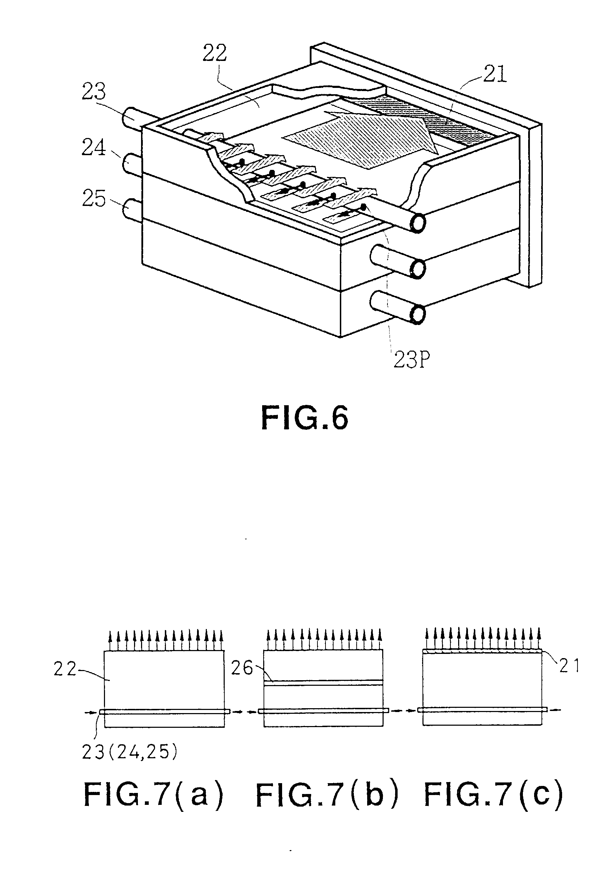

Furthermore, modifications may be adopted as shown in Figs. 5 and 6.

Figs. 5(a) and 5(b) show an arrangement in which round rods 26 are introduced in the buffer tank 22 of the gas introducing unit shown in Fig. 4, and the flow rate of each gas is made further uniform by means of the gaps formed respectively between this round rod 26 and each of the upper and lower walls of the buffer tank 22.

In addition, Fig. 6 shows an arrangement in which a filter 21 is provided at a leading end of the buffer tank 22 of the gas introducing unit, and the flow rate of the gas is made further uniform by means of this filter.

The distributions of the flow rates when these gas introducing units are used are respectively shown in Figs. 7(a) to 7(c). Thus it can be seen that it is possible to obtain very uniform distributions of flow rates. It should be noted that in a case where doping is carried out in the apparatus shown in Fig. 1, a doping gas such as PH₃ may be used by being added to the source gas.

In addition, if a slight amount of a reducing gas such as a hydrogen chloride or chlorine gas is added to the seal gas in advance, even if a decomposed substance adheres to the inner wall of the chamber, the adhering substance is removed by this gas and is exhausted. Hence, the life of the apparatus is increased further, and it is possible to form an epitaxially grown film having excellent crystallinity.

Furthermore, although a laminar flow of three layers is used in the above-described embodiment, two layers may be used, or four or more layers may be used.

Additionally, although a description has been given of an atmospheric-pressure CVD apparatus in the above-described embodiment, it goes without saying that the present invention is also applicable to a reduced-pressure CVD apparatus, an etching apparatus, and the like.

Furthermore, it goes without saying that it is possible to form thin films which are very highly selective in the selective epitaxial growth.

Next, a description will be given of an apparatus for introducing a gas in accordance with a second embodiment of the present invention.

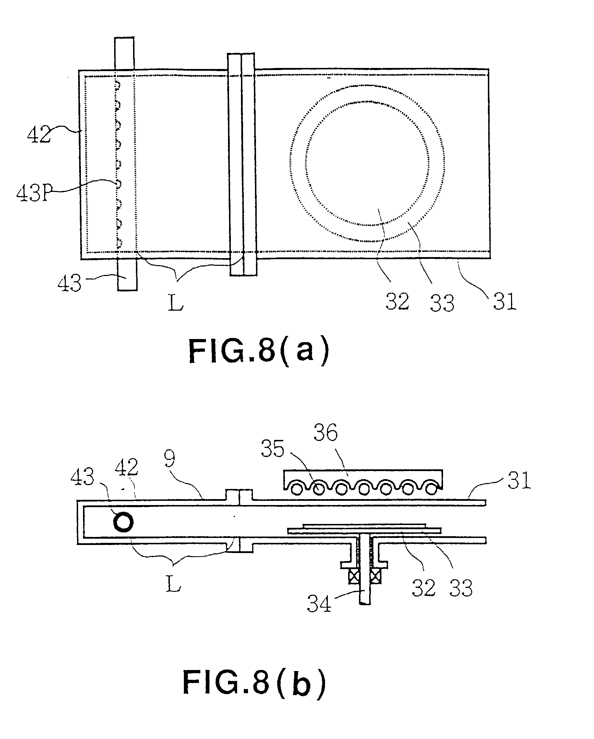

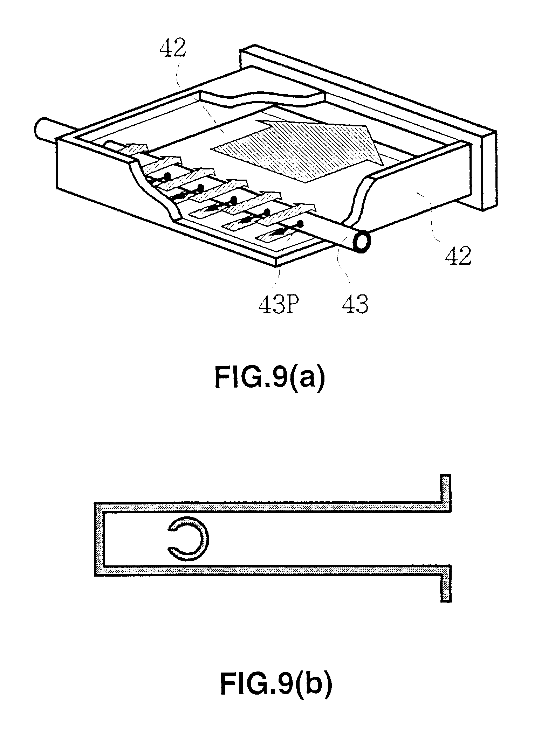

Its overall view is shown in Figs. 8(a) and 8(b) and an enlarged view of its gas introducing portion is shown in Figs. 9(a) and 9(b). This apparatus is characterized in that one layer of the gas introducing unit shown in Figs. 4 to 6 in the foregoing embodiment is used as the gas introducing portion, and that the gas is supplied in a state in which the distribution of the flow rate is uniform.

Namely, in this apparatus, a susceptor 33 for placing a wafer 32 thereon is disposed in a reaction furnace 31, and is rotated by means of a rotating shaft 34. The wafer 32 is heated by infrared lamps 35 from outside the reaction furnace, and the gas is supplied, thereby forming a desired thin film. The gas introducing portion is arranged such that the gas is supplied in a direction away from the reaction furnace 31, i.e., toward the rear surface of a buffer tank 42, through lateral holes 43P arranged at predetermined intervals in a gas introducing pipe 43 which is formed in such a manner as to pass through the interior of the buffer tank 42. After colliding against the rear surface, the gas passes through gaps formed respectively between the gas introducing pipe 43 and each of the upper and lower walls of the buffer tank 42, thereby making it possible to obtain a uniform flow rate in the widthwise direction.

According to this apparatus, after the gas collides against the rear surface of the buffer tank 42, the gas is dispersed when passing through the gaps formed respectively between the gas introducing pipe 43 and each of the upper and lower walls of the buffer tank 42. Subsequently, while the gas passes through an entrance section L from the buffer tank 42 to an inlet port of the reaction furnace 31, the flow rate becomes uniform in the widthwise direction, and the gas enters the reaction furnace 31.

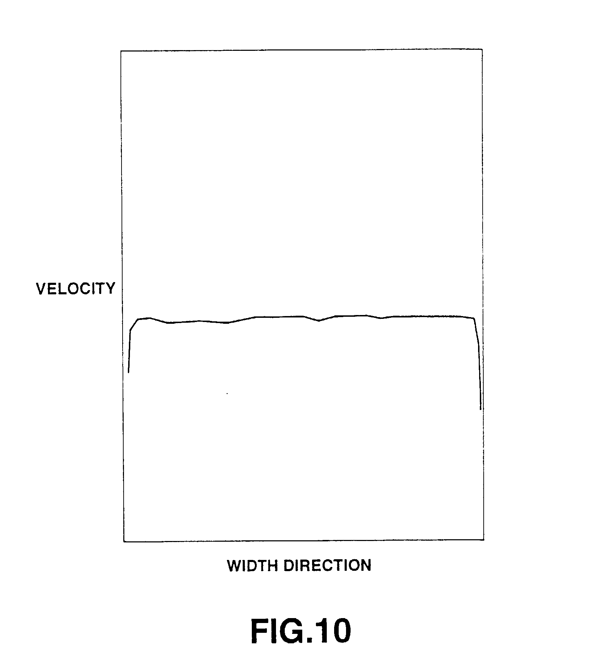

In this arrangement, since the gas after being dispersed is made to flow through the entrance section L, it is possible to form a very uniform flow in the widthwise direction, as shown in Fig. 10.

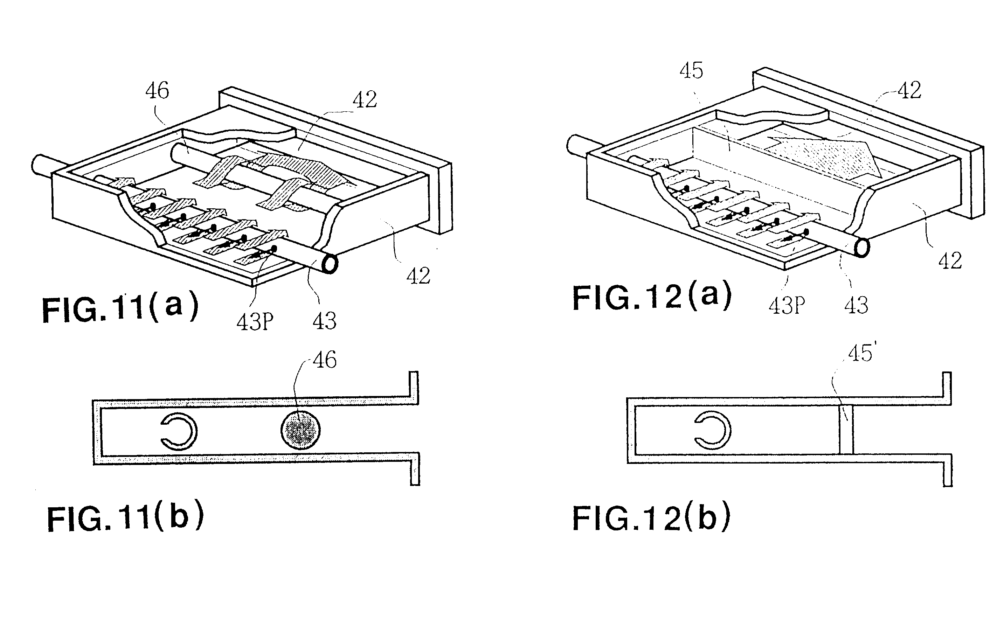

It should be noted that this gas introducing portion is not confined to this structure, and it is possible to adopt structures such as those shown in Figs. 11 to 15 as modifications.

Namely, Figs. 11(a) and 11(b) show an arrangement in which another round rod 46 is disposed in the buffer tank 42, so that the flow rate of the gas is made further uniform by means of the gaps between this round rod 46 and each of the upper and lower walls of the buffer tank 42.

Figs. 12(a) and 12(b) show an arrangement in which a mesh 45 is provided instead of the round rod 46, so that the flow rate of the gas is made further uniform by means of this mesh 45.

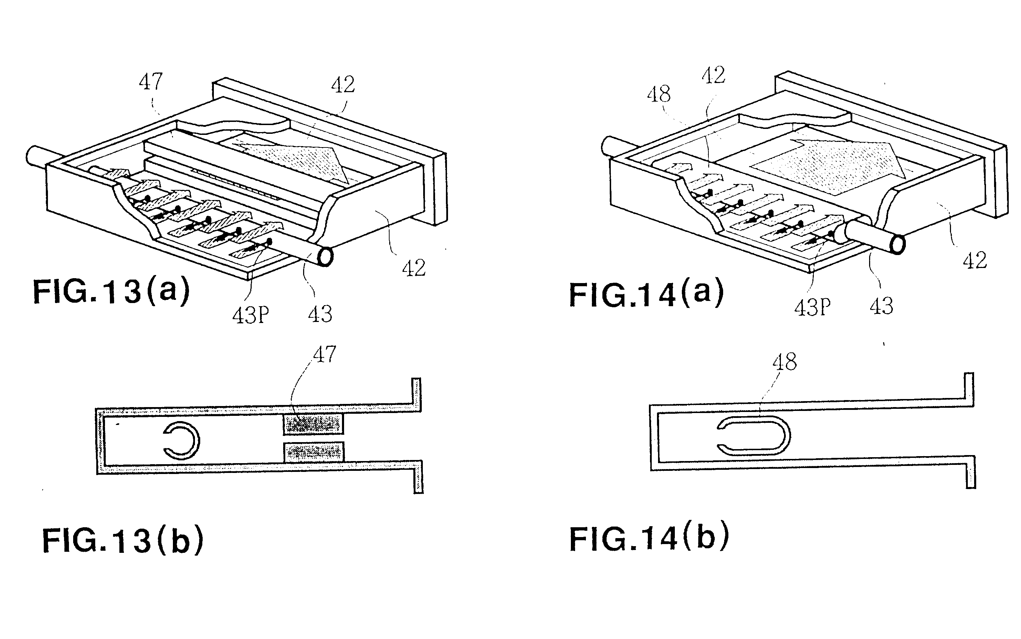

Figs. 13(a) and 13(b) show an arrangement in which a slit 47 is provided instead of the round rod 46, so that the flow rate of the gas is made further uniform by means of this slit 47.

Figs. 14(a) and 14(b) show an arrangement in which an elliptical rod 48 is disposed around the gas introducing pipe 43, so that the flow rate of the gas is made uniform by means of gaps between this elliptical rod and each of the upper and lower walls of the buffer tank 42.

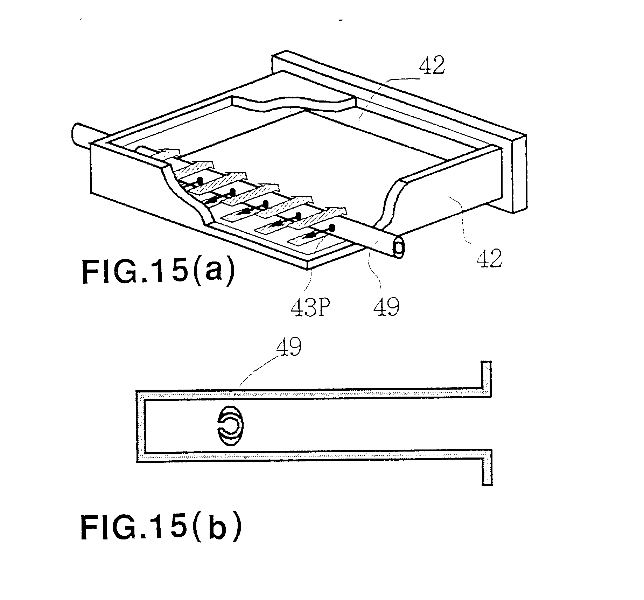

Furthermore, it is possible to use an elliptical rod 49 such as the one shown in-Figs. 15(a) and 15(b).

Referring next to the drawings, a detailed description will be given of a structure being different from the claims.

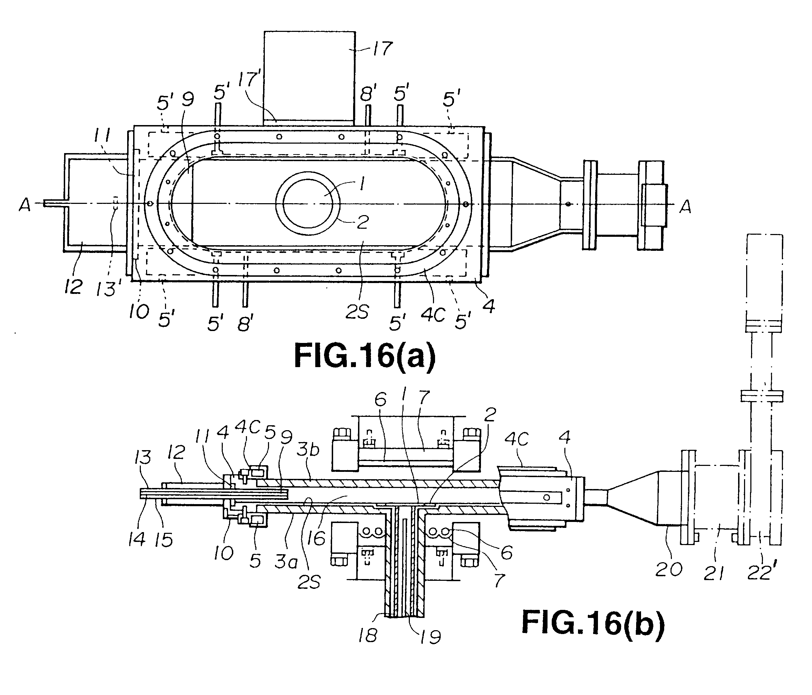

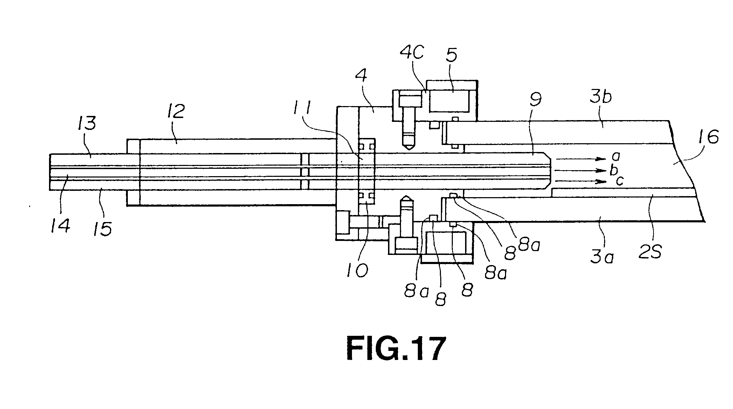

Figs. 16(a) and 16(b) are schematic diagrams of a CVD apparatus used in the method for epitaxial growth in accordance with this structure, and Fig. 17 is an enlarged view of an essential portion.

This CVD apparatus is characterized in that three gas inlet ports for supplying gases into the chamber 16 are formed starting with an inner wall side of the chamber, including the seal gas inlet port 13, the carrier gas inlet port 14, and the source gas inlet port 15, and the respective gases are arranged to flow through the chamber by forming a laminar flow of three layers by means of the shroud 9 via the buffer tank 12 which is divided into three chambers. The mesh-like filter 11 made of a metal or quartz is mounted between the buffer tank 12 and the shroud 9 by means of the plate 10 so as to make uniform the flow rate of the gas in each layer. Here, a hydrogen H₂ gas or the H₂ gas with hydrogen chloride HCl added is supplied from the seal gas inlet port 13; the H₂ gas is supplied from the carrier gas inlet port 14; and SiHCl₃ diluted with H₂ is supplied from the source gas inlet port 15. The gases introduced into the chamber 16 are exhausted via the duct 20, the bellows flange 21, the gate valve 22', and the like.

In addition, the chamber 16 is characterized by comprising the two elliptical quartz plates 3a, 3b which are optically ground and polished, and which are disposed in parallel with each other with a predetermined interval therebetween, and the stainless side wall plate 4 disposed in such a manner as to clamp these members and cover their peripheries. It should be noted that this side wall plate 4 is coated with amorphous tantalum, and its outer side has a water-cooled structure.

These two elliptical quarts plates 3a, 3b are sealed by the O-rings 8 by means of the water-cooled stainless cover 4C, and are attached to the side wall plate 4.

The gas is supplied from the gas inlet port 13 toward the duct 20 so that the reactive gas will be introduced along the longitudinal axis of the elliptical shape.

The wafer 1 is placed on the susceptor 2 disposed in this chamber 16 by means of a load lock 17, so as to allow epitaxial growth to take place.

Here, the O-rings 8 are cooled by the water-cooled jacket 5 to maintain their sealing properties even at a high temperature. A space enclosed by the three O-rings 8 is purged with an N₂ gas so as to make it possible to provide shielding from the atmosphere and detect the leakage of the SiHCl₃ gas and he H₂ gas.

Further, this susceptor 2 is formed of high-purity graphite in which a counterbore is formed in a wafer-placing portion, and whose surface is coated with SiC. The susceptor 2 is mounted on the rotating shaft of the rotating means 18 having the rotating cylinder provided on the quartz plate 3a. Also, the optical fiber 19 is mounted in this rotating cylinder so as to permit the monitoring of the temperature of the reverse surface of the wafer.

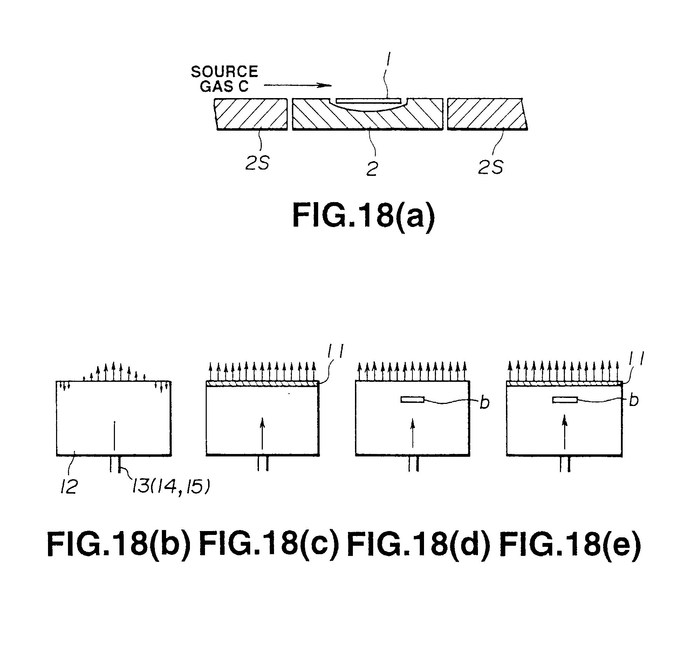

Furthermore, the second susceptor 2S formed of quartz is mounted on the surface of the quartz plate 3a such that its upper surface becomes substantially flush with the obverse surface of the wafer 1 on the susceptor 2, as an enlarged view of an essential portion is shown in Fig. 18(a), so as to introduce the gas satisfactorily.

The counterbore provided in the susceptor 2 serves to suppress the occurrence of crystal dislocation and to prevent the turbulence of a gas flow at an edge of the wafer by making the surface of the wafer flush with or lower than those of the susceptors 2, 2S.

The wafer is heated by the infrared lamps 6 which are disposed outside the quartz plates 3a and 3b at upper and lower positions in directions which are perpendicular to each other. These infrared lamps are provided with the reflectors 7 whose inner walls are plated with gold, so as to enhance the thermal efficiency.

By using this apparatus, the silicon wafer 1 is placed on the susceptor 2 by means of the load lock 17, and gases in a three-layered structure are introduced from the gas inlet ports 13, 14, 15 toward the silicon wafer 1. The temperature of the reverse surface of the wafer is detected by the optical fiber 19. On the basis of the detected value, the amount of light from the infrared lamps is controlled, thereby adjusting the wafer temperature with high accuracy.

Next, a description will be given of a method for epitaxial growth using this apparatus.

First, the silicon wafer is set in the load lock 17 purged with the N₂ gas.

Then, the nitrogen N₂ gas is supplied from the gas inlet ports 13, 14, 15 to purge the interior of the chamber 16 with N₂.

Subsequently, the hydrogen H₂ gas is supplied from the gas inlet ports 13, 14, 15 to purge the interior of the chamber 16 with H₂, and the interior of the chamber is heated to 900°C by the infrared lamps 6. The silicon wafer 1 is placed on the susceptor 2 from the load lock 17 by automatic transport, and the susceptor 2 is rotated by means of the rotating means 18.

The wafer 1 is further heated to 1150 - 1200°C through RTP (rapid thermal processing) using the infrared lamps 6. Subsequently, a very small amount of an HCl gas is added to the H₂ gas being introduced from the gas inlet port 15 so as to etch the wafer surface, thereby removing a natural oxide film on the wafer surface.

Subsequently, the wafer is cooled to 1000 - 1150°C in the H₂ atmosphere.

When the epitaxial growth temperature is reached, the hydrogen H₂ gas or the H₂ gas with hydrogen chloride HCl added is supplied from the seal gas inlet port 13; the H₂ gas is supplied from the carrier gas inlet port 14; and SiHCl₃ diluted with H₂ is supplied from the source gas inlet port 15. These supplying conditions and the like are shown in the table below.

**Table 2**

| | |
|---|---|
| Growth temperature | 1150°C |
| First seal gas H₂ | 100 SLM |
| Second seal gas H₂ | 200 SLM |
| Source SiHCl₃/Carrier gas H₂ | 15g/min |
| | 60 SLM |
| Thickness of epitaxial film | 10µm |
| Growth speed | 5µm/min |

When the gases were supplied under the above supplying conditions, the distribution of the flow rate in each layer was a laminar flow, as shown in Fig. 18(c).

The hydrogen H₂ gas supplied from the seal gas inlet port 13 flowed along the upper quartz plate 3b; the H₂ gas supplied from the carrier gas inlet port 14 flowed in a central portion of the chamber; and SiHCl₃ diluted with H₂ introduced from the source gas inlet port 15 flowed along the wafer surface, thereby forming an epitaxially grown silicon film on the wafer surface.

The epitaxially grown film thus obtained is a film which is slip-free and excellent in crystallinity, and there is no risk of the occurrence of automatic doping or pattern shift.

Furthermore, since the inner wall of this stainless plate is covered with amorphous tantalum which has very low reactivity and is stable, it is possible to form an epitaxial thin film which is very stable and highly reliable.

Then, the wafer is taken out by means of the load lock 17, the operation returns to the initial process after the N₂ purge, i.e., the H₂ gas supplying process, and the same process is repeated in a similar manner. Thus, since it becomes possible to effect epitaxial growth without adherence of amorphous silicon which causes the occurrence of particles, it becomes possible to omit the HCl gas etching of the inner wall of the chamber which was essential after epitaxial growth, thereby making it possible to conduct epitaxial growth on a continuous basis.

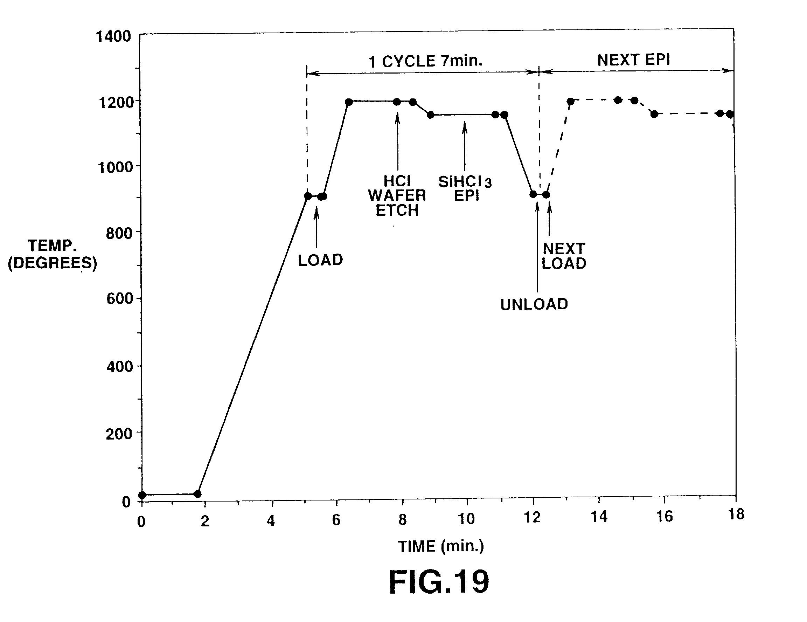

The time chart of this process is shown in Fig. 19. As is apparent from a comparison between this graph and the conventional time chart shown in Fig. 25, in accordance with the method of the present invention, since the HCl gas etching of the inner wall of the chamber can be omitted, the time required for one cycle in the case of 10 µm growth becomes 7 minutes (in which the film-forming time is 2 minutes). Thus it can be appreciated that the time required for one cycle is reduced substantially as compared with the conventional 10 minutes. Here, in accordance with the method of the present invention, the throughput (the number of wafers processed per unit time) becomes 8.6 wafers/hr, representing an improvement by approximately 40% as compared with the conventional 6 wafers/hr.

Although in the above-described structure the flow rate in each layer is made uniform by the use of the filter 11, the baffle plate b instead of the filter may be inserted in the buffer tank (Fig. 18(d)), or both the filter and the baffle plate b may be used (Fig. 18(e)). In accordance with the invention, a rectifying means such as those shown in Figs. 4 to 6 is used. Here, in a case where no filter or other device is used, the rate of flow in the layer does not become uniform and a turbulent flow is formed, as shown in Fig. 18(b).

It should be noted that although SiHCl₃ is used as the source gas in the above-described embodiment, the present invention is not confined to the same, and SiH₄, SiH₂Cl₂, SiCl₄ or the like may be used.

In addition, when doping is conducted, a doping gas such as PH₃ may be used by being added to the source gas.

If a slight amount of a reducing gas such as a hydrogen chloride or chlorine gas is added to the seal gas in advance, even if the decomposed substance adheres to the inner wall of the chamber, the adhering substance is removed by this gas and is exhausted. Hence, the life of the apparatus is increased further, and it is possible to form an epitaxially grown film having excellent crystallinity on a continuous basis without undergoing the chamber etching process.

Furthermore, although a laminar flow of three layers is used in the above-described embodiment, two layers may be used, or four or more layers may be used.

Additionally, although a description has been given of an atmospheric-pressure CVD apparatus in the above-described embodiment, it goes without saying that the present invention is also applicable to a reduced-pressure CVD apparatus, an etching apparatus, and the like.

Furthermore, it goes without saying that it is possible to form thin films which are very highly selective in the selective epitaxial growth.

As described above, in accordance with the present invention, since the gas is supplied in such a manner as to form a laminar flow of a multilayered structure along the surface of the wafer so as to effect epitaxial growth on the wafer surface, it is possible to prevent the reactive gas from flowing round to the inner wall of the chamber and adhering to the inner wall by being decomposed. Thus, it is possible to use a highly decomposable SiH₄ gas or the like as a source gas, so that it is possible to form an epitaxially grown film which is highly reliable at a low temperature.

In addition, in accordance with the present invention, since the epitaxial growth is carried out while a gas which is low in reactivity is allowed to flow along the inner wall of the chamber as the seal gas, it is possible to prevent the decomposed substance from reaching the inner wall of the chamber, thereby making it possible to maintain the inner wall in an excellent condition without an adhering substance.

Furthermore, in accordance with the present invention, since the laminar flow-forming means for introducing a gas in such a manner as to form a laminar flow of a multilayered structure along the wafer surface is disposed at a gas inlet port of the apparatus for epitaxial growth, the reactive gas is supplied in such a manner as to-form a laminar flow of a multilayered structure along the wafer surface. Hence, it is possible to prevent the reactive gas from flowing round to the inner wall of the chamber and adhering to the inner wall by being decomposed. Thus, it is possible to use a highly decomposable SiH₄ gas or the like as a source gas, so that it is possible to form an epitaxially grown film which is highly reliable at a low temperature.

In accordance with the present invention, the gas introducing portion is arranged such that the gas is supplied toward the rear surface of the buffer tank and is caused to collide against the rear surface through lateral holes arranged at predetermined intervals in a gas introducing pipe formed in such a manner as to pass through the interior of the buffer tank, whereupon the gas passes through gaps formed respectively between the gas introducing pipe and each of the upper and lower walls of the buffer tank, thereby making it possible to obtain a uniform flow rate in the widthwise direction. Accordingly, the present invention is applicable to various apparatuses such as an apparatus for gaseous-phase growth, an etching apparatus, and the like.

In accordance with the present invention, the arrangement provided is such that the gas is supplied in such a manner as to form a laminar flow of a multilayered structure along the surface of the wafer, and epitaxial growth is allowed to take place on the surface of the wafer. Accordingly, it is possible to prevent the reactive gas from flowing round to the inner wall of the chamber and adhering to the inner wall by being decomposed, and it is possible to form on a continuous basis an epitaxially grown film which is highly reliable.

## Claims

1. An apparatus for epitaxial growth, comprising:
a reaction chamber (16);
a substrate-supporting base (2) disposed in said reaction chamber (16) so as to support a substrate (1) to be processed;
a plurality of laminar flow-forming units stacked one over another for supplying a laminar gas flow of a multilayered structure along a surface of said substrate to be processed, each of said laminar flow-forming units comprising:
a rectangular chamber whose cross-section has a high aspect ratio and which has one end connected to said reaction chamber (16);
a gas introducing pipe (23 to 25) attached to a vicinity of another end of said rectangular chamber so as to blow the gas toward said another end, i.e., toward a rear surface, of said rectangular chamber; and
a slit portion formed between an outer wall of said gas introducing pipe (23 to 25) and a wall surface of said rectangular chamber, the rectangular chambers being connected to the reaction chamber (16). and
heating means (6) for heating said substrate (1) to be processed,
whereby epitaxial growth is caused to take place on the surface of said substrate (1) to be processed.

2. An apparatus for epitaxial growth according to claim 1, wherein said heating means (6) effects heating by means of radiant heat.

3. An apparatus for epitaxial growth according to claim 1 or 2, characterized by further comprising a round rod (46), a slit (47), or a mesh (45), provided between said slit portion and said reaction chamber (16).

4. An apparatus for epitaxial growth according to anyone of claims 1 to 3, wherein the laminar gas flow of a multilayered structure is composed of, from the surface side of said substrate (1) to be processed, a first layer flow including a source gas containing a substance which serves as a source of formation of the epitaxial growth layer and a second layer flow constituted by a seal gas for sealing said first layer flow.

5. A method for epitaxial growth, comprising:
a placing step in which a substrate (1) to be processed is placed in a reaction chamber (16), and
an epitaxial-growth step in which a laminar gas flow of a multilayered structure is supplied from a plurality of laminar flow-forming units stacked one over another along the surface of said substrate (1) to be processed, so as to form an epitaxial growth layer on the surface of said substrate (1) to be processed, each of said laminar flow-forming units comprising:
a rectangular chamber whose cross-section has a high aspect ratio and which has one end connected to said reaction chamber (16);
a gas introducing pipe (23 to 25) attached to a vicinity of another end of said rectangular chamber so as to blow the gas toward said another end, i.e., toward a rear surface, of said rectangular chamber; and
a slit portion formed between an outer wall of said gas introducing pipe (23 to 25) and a wall surface of said rectangular chamber, the rectangular chambers being connected to the reaction chamber (16).

6. A method for epitaxial growth according to claim 5, wherein the laminar gas flow of a multilayered structure is composed of, from the surface side of said substrate to be processed. a first layer flow including a source gas containing a substance which serves as a source of formation of the epitaxial growth layer and a second layer flow constituted by a seal gas for sealing said first layer flow.

7. A method for exitaxial growth according to claim 6, wherein said first layer flow is constituted by a mixed gas of silane (SiH₄) and hydrogen (H₂).

8. A method for epitaxial growth according to claim 6 or 7, wherein said second layer flow is a laminar flow of a two-layered structure of a hydrogen gas and a gas containing a reducing substance.

9. A method for epitaxial growth according to anyone of claims 5 to 8, further comprising:
a substrate-to-be-processed removing step in which the temperature of said substrate (1) to be processed is lowered, and said substrate (1) to be processed is removed from said reaction chamber (16);
a second placing step in which another substrate (1) to be processed is placed in said reaction chamber (16);
a second epitaxial-growth step in which the temperature of said another substrate (1) to be processed is increased again to the growth temperature, and the laminar gas flow of a multilayered structure is supplied along the surface of said another substrate (1) to be processed, so as to form an epitaxial growth layer on the surface of said another substrate (1) to be processed; and
a substrate-to-be-processed removing step in which the temperature of said another substrate (1) is lowered, and said another substrate (1) to be processed is removed from said reaction chamber (16),
wherein two or more steps of epitaxial growth are conducted on a continuous basis without undergoing a temperature-increasing step between the steps.

10. An apparatus for introducing a gas, comprising:
a rectangular buffer tank (42) connectable to one end of a reaction chamber (31) to which the gas is to be introduced and having a cross-section with a high aspect ratio,
a gas introducing pipe (43) disposed to pass through side walls of the buffer tank (42) at a vicinity of a rear wall of the buffer tank so as to be in parallel to the rear wall and the upper and lower walls, the gas introducing pipe having apertures (43P) formed to face the rear wall at predetermined intervals; and
a slit portion formed between the gas introducing pipe and the upper and lower walls of the buffer tank,
wherein the gas is blown out from the apertures (43P) of the gas introducing pipe (43) towards the back side of the buffer tank (42), and is led through the slit portion into the reaction chamber (31).

11. An apparatus for introducing a gas according to claim 10, characterized by further comprising a round rod (46), a slit (47), or a mesh (45), provided between the slit portion and the reaction chamber.

## Patentansprüche

1. Gerät für epitaktisches Wachstum, mit
einer Reaktionskammer (16),
einer substrathaltenden Basis (2), die in der Reaktionskammer (16) so angeordnet ist, daß sie ein zu bearbeitendes Substrat (1) trägt,
einer Mehrzahl von eine laminare Strömung bildenden Einheiten, die zum Speisen einer laminaren Gasströmung mit einem mehrlagigen Aufbau entlang einer Oberfläche des zu bearbeitenden Substrats übereinander gestapelt sind, wobei jede der eine laminare Strömung bildenden Einheiten enthält:
eine rechteckförmige Kammer, deren Querschnitt ein hohes Seitenverhältnis aufweist und die ein mit der Reaktionskammer (16) verbundenes Ende umfaßt,
ein Gaseinleitungsrohr (23 bis 25), das in der Nähe des anderen Endes der rechteckförmigen Kammer so angebracht ist, daß das Gas in Richtung zu dem anderen Ende, das heißt in Richtung zu einer rückseitigen Oberfläche der rechteckförmigen Kammer geblasen wird, und
einen Schlitzbereich, der zwischen einer Außenwand des Gaseinleitungsrohrs (23 bis 25) und einer Wandoberfläche der rechteckförmigen Kammer ausgebildet ist, wobei die rechteckförmigen Kammern mit der Reaktionskammer (16) verbunden sind, und
einer Heizeinrichtung (6) zum Heizen des zu bearbeitenden Substrats (1),
wodurch ein epitaktisches Wachstum hervorgerufen wird, das auf der Oberfläche des zu bearbeitenden Substrats (1) stattfindet.

2. Gerät für epitaktisches Wachstum nach Anspruch 1, bei dem die Heizeinrichtung (7) eine Aufheizung mit Hilfe von Strahlungswärme bewirkt.

3. Gerät für epitaktisches Wachstum nach Anspruch 1 oder 2, dadurch gekennzeichnet, daß es weiterhin einen runden Stab (46), einen Schlitz (47) oder ein Gitter (45) aufweist, der bzw. das zwischen dem Schlitzbereich und der Reaktionskammer (16) vorgesehen ist.

4. Gerät für epitaktisches Wachstum nach einem der Ansprüche 1 bis 3, bei dem die laminare Gasströmung mit einem mehrlagigen Aufbau von der Oberflächenseite des zu bearbeitenden Substrats (1) her gesehen aus einer ersten Lagenströmung, die ein Quellengas enthält, das eine als eine Quelle zur Erzeugung der epitaktisch aufgewachsenen Schicht dienende Substanz umfaßt, und einer zweiten Lagenströmung zusammengesetzt ist, die durch ein Abdichtungsgas zum Abdichten der ersten Lagenströmung gebildet ist.

5. Verfahren für epitaktisches Wachstum, mit
einem Anordnungsschritt, bei dem ein zu bearbeitendes Substrat (1) in einer Reaktionskammer (16) angeordnet wird, und
einem epitaktischen Wachstumsschritt, bei dem eine laminare Gasströmung mit einem mehrlagigen Aufbau von einer Mehrzahl von eine laminare Strömung bildenden Einheiten zugeführt wird, die entlang der Oberfläche des zu bearbeitenden Substrats so aufeinander gestapelt sind, daß eine epitaktisch aufgewachsene Schicht auf der Oberfläche des zu bearbeitenden Substrats (1) gebildet wird, wobei jede der eine laminare Strömung bildenden Einheiten umfaßt:
eine rechteckförmige Kammer, deren Querschnitt ein hohes Seitenverhältnis aufweist und die ein mit der Reaktionskammer (16) verbundenes Ende umfaßt,
ein Gaseinleitungsrohr (23 bis 25), das in der Nähe des anderen Endes der rechteckförmigen Kammer so angebracht ist, daß das Gas in Richtung zu dem anderen Ende, das heißt in Richtung zu einer rückseitigen Oberfläche der rechteckförmigen Kammer, geblasen wird, und
einen Schlitzbereich, der zwischen einer Außenwand des Gaseinleitungsrohres (23 bis 25) und einer Wandoberfläche der rechteckförmigen Kammer gebildet ist, wobei die rechteckförmigen Kammern mit der Reaktionskammer (16) verbunden sind.

6. Verfahren für epitaktisches Wachstum nach Anspruch 5, bei dem die laminare Gasströmung mit einem mehrlagigen Aufbau von der Oberflächenseite des zu bearbeitenden Substrats her gesehen aus einer ersten Lagenströmung, die ein Quellengas enthält, das eine als eine Quelle zur Erzeugung der epitaktisch wachsenden Schicht dienende Substanz umfaßt, und einer zweiten Lagenströmung zusammengesetzt ist, die durch ein Abdichtungsgas zum Abdichten der ersten Lagenströmung gebildet ist.

7. Verfahren für epitaktisches Wachstum nach Anspruch 6, bei dem die erste Lagenströmung durch ein Mischgas aus Silan (SiH₄) und Wasserstoff (H₂) gebildet ist.

8. Verfahren für epitaktisches Wachstum nach Anspruch 6 oder 7, bei dem die zweite Lagenströmung eine laminare Strömung mit einem zweilagigen Aufbau aus einem Wasserstoffgas und einem eine reduzierende Substanz enthaltenden Gas ist.

9. Verfahren für epitaktisches Wachstum nach einem der Ansprüche 5 bis 8, das weiterhin umfaßt:
einen Schritt zur Herausnahme des zu bearbeitenden Substrats, bei dem die Temperatur des zu bearbeitenden Substrats (1) abgesenkt wird und das zu bearbeitende Substrat (1) aus der Reaktionskammer (16) herausgenommen wird,
einen zweiten Anbringungsschritt, bei dem ein weiteres zu bearbeitendes Substrats (1) in der Reaktionskammer (16) angeordnet wird,
einen zweiten Schritt mit epitaktischem Wachstum, bei dem die Temperatur des weiteren, zu bearbeitenden Substrats (1) wieder auf die Wachstumstemperatur erhöht wird und die laminare Gasströmung mit einem mehrlagigen Aufbau entlang der Oberfläche des weiteren, zu bearbeitenden Substrats (1) zugeführt wird, um hierdurch eine epitaktisch aufgewachsene Schicht auf der Oberfläche des weiteren, zu bearbeitenden Substrats (1) zu bilden, und
einen Schritt zur Herausnahme des zu bearbeitenden Substrats, bei dem die Temperatur des weiteren Substrats (1) abgesenkt wird und das weitere. zu bearbeitende Substrat (1) aus der Reaktionskammer (16) herausgenommen wird,
wobei zwei oder mehr Schritte für ein epitaktisches Wachstum auf kontinuierlicher Basis ausgeführt werden, ohne daß ein Temperaturerhöhungsschritt zwischen den Schritten durchgeführt wird.

10. Gerät zum Einleiten eines Gases mit
einem rechteckförmigen Puffertank (42), der mit einem Ende einer Reaktionskammer (31) verbindbar ist, in die das Gas einzuleiten ist und die einen Querschnitt mit einem hohen Seitenverhältnis aufweist,
einem Gaseinleitungsrohr (43), das so angeordnet ist, daß es durch Seitenwände des Puffertanks (42) in der Nähe einer rückseitigen Wand des Puffertanks derart hindurchgeführt ist, daß es parallel zu der rückseitigen Wand und der oberen und unteren Wand verläuft, wobei das Gaseinleitungsrohr Offnungen (43P) aufweist, die so ausgebildet sind, daß sie der rückseitigen Wand mit vorbestimmten Abständen zugewandt sind, und
einem Schlitzbereich, der zwischen dem Gaseinleitungsrohr und der oberen und unteren Wand des Puffertanks gebildet ist,
wobei das Gas aus den Offnungen (43P) des Gaseinleitungsrohrs (43) in Richtung zu der Rückseite des Puffertanks (42) ausgeblasen und durch den Schlitzbereich in die Reaktionskammer (31) geleitet wird.

11. Gerät zum Einleiten eines Gas gemäß Anspruch 10, dadurch gekennzeichnet, daß es weiterhin einen runden Stab (46), einen Schlitz (47) oder ein Gitter (45) enthält, der bzw. das zwischen dem Schlitzbereich und der Reaktionskammer vorgesehen ist.

## Revendications

1. Appareil de croissance épitaxiale, comprenant :
une chambre de réaction (16) ;
une base porte-substrats (2) disposée dans ladite chambre de réaction (16) de manière à supporter un substrat (1) à traiter ;
une pluralité d'unités de formation de flux laminaire empilées les unes sur les autres afin de fournir un flux de gaz laminaire avec structure multicouches le long d'une surface dudit substrat à traiter, chacune desdites unités de formation de flux laminaire comprenant:
une chambre rectangulaire dont la section transversale présente un rapport d'aspect élevé et dont une extrémité est connectée à ladite chambre de réaction (16),
un tube d'introduction de gaz (23 à 25) attaché au voisinage d'une autre extrémité de ladite chambre rectangulaire de manière à souffler le gaz vers ladite autre extrémité, c'est-à-dire vers une surface postérieure, de ladite chambre rectangulaire, et
une partie fendue formée entre une paroi extérieure dudit tube d'introduction de gaz (23 à 25) et une surface de paroi de ladite chambre rectangulaire, la chambre rectangulaire étant connectée à la chambre de réaction (16) ; et
des moyens de chauffage (6) afin de chauffer ledit substrat (1) à traiter, dans lequel la croissance épitaxiale est amenée à se produire sur la surface dudit substrat (1) à traiter.

2. Appareil pour croissance épitaxiale selon la revendication 1, dans lequel lesdits moyens de chauffage (6) effectuent le chauffage au moyen d'une chaleur par rayonnement.

3. Appareil pour croissance épitaxiale selon l'une ou l'autre des revendications 1 et 2, caractérisé en ce qu'il comprend en outre une barre circulaire (46), une fente (47), ou un engrènement (45), prévue entre ladite partie fendue et ladite chambre de réaction (16).

4. Appareil pour croissance épitaxiale selon l'une quelconque des revendications 1 à 3, dans lequel le flux de gaz laminaire à structure multicouches est composé, partant du côté de la surface dudit substrat (1) à traiter, d'une première couche de flux qui inclut un gaz source contenant une substance qui sert de source pour formation de la couche de croissance épitaxiale, et par une deuxième couche de flux constituée par un gaz d'isolement afin d'isoler ladite première couche de flux.

5. Procédé de croissance épitaxiale, comprenant:
une étape de mise en place dans laquelle un substrat (1) à traiter est placé dans une chambre de réaction (16), et
une étape de croissance épitaxiale dans laquelle un flux de gaz laminaire à structure multicouches est fourni depuis une pluralité d'unités de formation de flux laminaire empilées les unes sur les autres le long de la surface dudit substrat (1) à traiter, de manière à former une couche de croissance épitaxiale sur la surface dudit substrat (1) à traiter, chacune desdites unités de formation de flux laminaire comprenant:
une chambre rectangulaire dont la section présente un rapport d'aspect élevé et dont une extrémité est connectée à ladite chambre de réaction (16);
un tube d'introduction de gaz (23 à 25) attaché au voisinage d'une autre extrémité de ladite chambre rectangulaire de manière à souffler le gaz vers ladite autre extrémité, c'est-à-dire vers une surface postérieure, de ladite chambre rectangulaire ; et
une partie fendue formée entre une paroi extérieure dudit tube d'introduction de gaz (23 à 25) et une surface de paroi de ladite chambre rectangulaire, la chambre rectangulaire étant connectée à la chambre de réaction (16).

6. Procédé de croissance épitaxiale selon la revendication 5, dans lequel le flux de gaz laminaire à structure multicouches est composé, partant depuis le côté de la surface dudit substrat à traiter, par un premier flux en couche qui inclut un gaz source contenant une substance qui sert de source de formation de la couche de croissance épitaxiale, et un deuxième flux en couche constitué par un gaz d'isolement afin d'isoler ledit premier flux en couche.

7. Procédé de croissance épitaxiale selon la revendication 6, dans lequel ledit premier flux en couches est constitué par un mélange gazeux de silane (SiH₄) et d'hydrogène (H₂).

8. Procédé de croissance épitaxiale selon l'une ou l'autre des revendications 6 et 7, dans lequel ledit deuxième flux en couche est un flux laminaire avec structure à deux couches d'hydrogène gazeux et d'un gaz contenant une substance réductrice.

9. Procédé de croissance épitaxiale selon l'une quelconque des revendications 5 à 8, comprenant en outre ;
une étape d'enlèvement du substrat à traiter, dans laquelle la température dudit substrat (1) à traiter est abaissée, et ledit substrat (1) à traiter est enlevé depuis ladite chambre de réaction (16) ;
une deuxième étape de mise en place dans laquelle un autre substrat (1) à traiter est placé dans ladite chambre de réaction (16);
une deuxième étape de croissance épitaxiale, dans laquelle la température dudit autre substrat (1) à traiter est à nouveau augmentée jusqu'à la température de croissance, et le flux de gaz laminaire à structure multicouches est fourni le long de la surface dudit autre substrat (1) à traiter, de manière à former une couche de croissance épitaxiale sur la surface dudit autre substrat (1) à traiter ; et
une étape d'enlèvement de substrat, dans laquelle la température dudit autre substrat (1) est abaissée, et ledit autre substrat (1) à traiter est enlevé depuis ladite chambre de réaction (16),
dans lequel une ou plusieurs étapes de croissance épitaxiale sont menées sur une base continue sans subir d'étape d'augmentation de température entre les étapes.

10. Appareil pour introduire un gaz, comprenant :
un réservoir tampon rectangulaire (42) susceptible d'être connecté à une extrémité d'une chambre de réaction (31) à laquelle le gaz doit être introduit, et présentant une section transversale avec un rapport d'aspect élevé,
un tube d'introduction de gaz (43) disposé de manière à traverser des parois latérales du réservoir tampon (42) au voisinage d'une paroi postérieure du réservoir tampon, de façon à être parallèle à la paroi postérieure et aux parois supérieure et inférieure, le tube d'introduction de gaz comportant des ouvertures (43P) formées à des intervalles prédéterminés en face de la paroi postérieure ; et
une partie fendue formée entre le tube d'introduction de gaz et les parois supérieure et inférieure du réservoir tampon,
dans lequel le gaz est soufflé depuis les ouvertures (43P) du tube d'introduction de gaz (43) vers le côté postérieur du réservoir tampon (42), et il est amené à travers la partie fendue jusque dans la chambre de réaction (31).

11. Appareil pour introduire un gaz, selon la revendication 10, caractérisé en ce qu'il comprend en outre une tige circulaire (46), une fente (47), ou un engrènement (45), prévue entre la partie fendue et la chambre de réaction.
